# EUROPEAN PATENT APPLICATION

(11) **EP 2 757 583 A1**
(43) Date of publication of application: **23.07.2014**
(21) Application number: 13151700.5
(22) Date of filing: 17.01.2013
(51) Int. Cl.: H01L 23/13, H01L 23/498, H01L 23/00

(54) **Chip on film, and method of manufacture thereof**

(71) Applicant: Funai Electric Co., Ltd., Daito-shi Osaka 574-0013 (JP)
(72) Inventor: Kondo, Hiroya, Osaka 574-0013 (JP)
(74) Representative: Giovannini, Francesca

(57) **Abstract**

A chip on film (1) includes a plastic film (2) approximately rectangular in flat view, a designated wiring pattern (12) having approximately rectangular electrodes (12a, 12b) arrayed longitudinally formed on a mounting surface of the plastic film (2), and an LSI chip (13) mounted on the mounting surface of the plastic film (2) and connected to the designated wiring pattern (12). At least one cutout part (3) is formed on each short side (2a) of the approximate rectangle of the plastic film (2).

## Description

### Field of the Invention

The present invention relates to a chip on film (COF) in which an LSI may be directly mounted on a film substrate, used, for example, in wiring of LCD panels etc., and a method of manufacture thereof. The film substrate may be a polyimide film substrate.

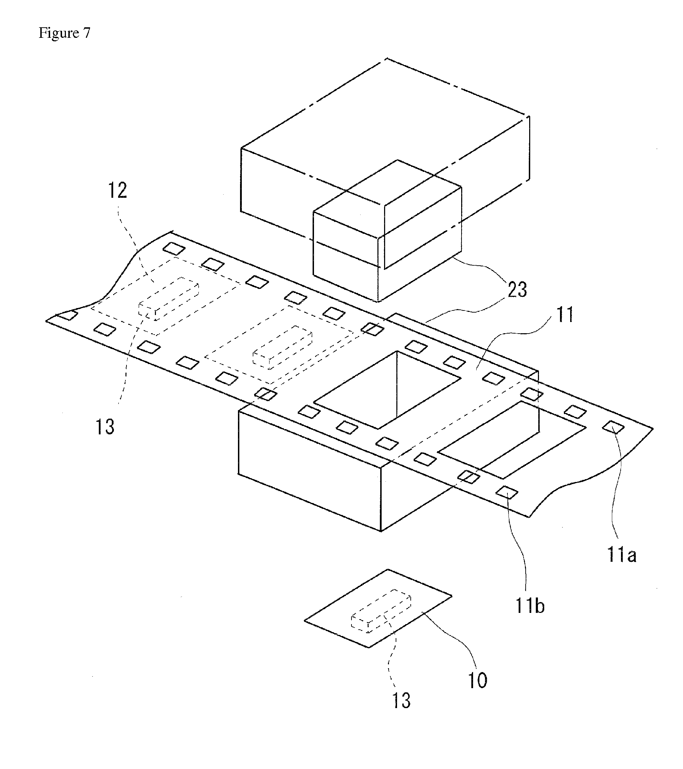

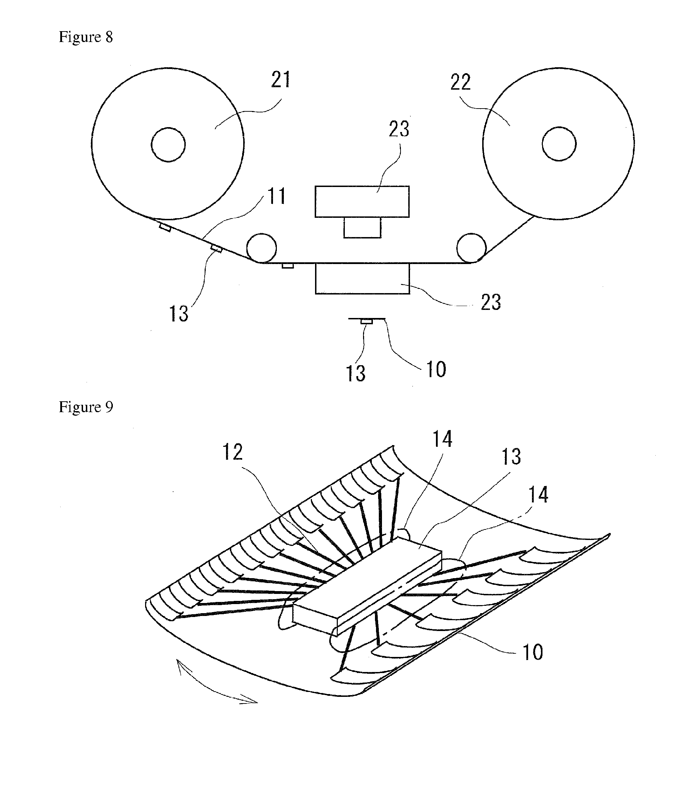

A chip on film 10, as shown in Figure 7, is manufactured by continuously forming a designated wiring pattern 12 at regular intervals on a film tape 11 of thermosetting resin such as polyimide fill etc., and mounting an LSI chip 13 on the wiring pattern 12, then punching out the parts of wiring pattern 12 on which LSI chips are mounted (see for example Cited Patent Documents 1 through 3). As shown in Figure 8, resin film tape 11 on which LSI chips 13 are mounted is wound around a first reel 21 at the supply source and a second reel 22 for take-up, and the chip on film 10 is punched into, for example, rectangular shapes by a tool 23 placed between first reel 21 and second reel 22. In this case, chip on film 10 is punched out from the non-mounting surface (back side) of LSI chip 13, with the mounting surface (front side) of LSI chip on the outside from resin film tape 11.

As shown in Figure 7, perforations 11a, 11b are formed on both sides of the resin film tape 11 along the longitudinal direction (direction of feed) thereof, and the part between perforations 11a and perforations 11b is punched out in rectangular shapes with the longitudinal direction forming the short side thereof. LSI chip 13 is, for example, rectangular in a flat view, and is mounted such that the long side thereof is parallel to the width direction (the direction perpendicular to the direction of feed) of the resin film. The periphery of LSI chip 13 is coated with an adhesive 14 for the purpose of attaching LSI ship 13 to resin film tape 11 (see Figure 9).

However, as shown in Figure 9, the chip on film 10 after it is punched out from resin film tape 11 is curved in the direction of the short side of the rectangular shape or, in other words, in the direction of feed of resin film tape 11, such that the mounting surface side of LSI chip 13 shrinks. One of the reasons for this is considered to be that adhesive 14 coated on the periphery of LSI chip 13 contracts as it hardens, thus generating stress in the direction that causes the LSI chip surface side to contract. Another reason is suspected to be that when resin film tape 11 is wound on first reel 21, tensile stress on the mounting surface side of LSI chip 13, however compressive stress is applied to the non-mounting surface side on the back side thereof. When the chip on film 10 is punched out from resin film tape 11, these stresses are released, such that the mounting surface side contracts and the non-mounting surface side expands. Another possibility is that these elements combine to act together.

The chip on film 10 is used for purposes such as connecting to thin film transistors (TFT) formed on the surface of liquid crystal display panels, and when curvature such as that described above occurs, the process of connection cannot be performed without problems. There is also the potential for reduced positioning accuracy when the chip on film 10 is attached.

### Patent References

Cited Patent Reference 1 Patent laid-open 2009-289844
Cited Patent Reference 2 Patent laid-open 2006-156856
Cited Patent Reference 3 Patent laid-open 2005-12017

One or more embodiments of the present invention provides a chip on film and a method of manufacture thereof, whereby flatness can be maintained without bending in the direction of contraction of the mounting surface of LSI chips in the direction of feed of resin film tape, even after punch out by means of a tool.

### Summary of the Invention

According to one aspect, the present invention provides a chip on film including a plastic film approximately rectangular in flat view, a designated wiring pattern having approximately rectangular electrodes arrayed longitudinally formed on a mounting surface of the plastic film, and an LSI chip mounted on the mounting surface of the plastic film and connected to the designated wiring pattern. At least one cutout part is formed on each short side of the approximate rectangle of the plastic film.

In one or more embodiments, the at least one cutout part may be shaped as one of an approximate semicircle, approximate half-oval, approximate U-shape, or approximate V-shape.

According to another aspect, the present invention provides a method of manufacture of a chip on film, the method including forming a designated wiring pattern at regular intervals on a plastic film tape, mounting an LSI chip on the wiring pattern, coating perimeters of the LSI chip with adhesive, and cutting out from the plastic film wiring pattern areas, with the LSI chip mounted, in an approximately rectangular form, wherein the long side is in the lateral direction of the plastic film tape, using a tool. The tool includes a male tool approximately rectangular in shape and formed with a cutout part in at least one place on a short side thereof and a female tool approximately rectangular in shape and of approximately the same size as the male tool, formed with protrusions mating with the cutout part in at least one place on a short side thereof, wherein a cutout part is formed in at least one place on each of both short sides of the rectangular form.

In one or more embodiments, the at least one cutout part may be shaped as one of an approximate semicircle, approximate half-oval, approximate U-shape, or approximate V-shape.

In one or more embodiments of the present invention, cutout parts are formed in the short side of an approximately rectangular chip on film punched out of resin film tape, for example in at least one place on the sides of the resin film tape in the direction of feed. For this reason, the force causing the chip on film to bend in the direction of shrinkage is dissipated or released by the presence of the cutout parts. As a result, even after being punched out by a tool, the chip on film is able to maintain excellent flatness.

### Brief Description of the Drawings

Figure 1 is a flat view of a chip on film according to one embodiment of the present invention;
Figure 2 is a perspective view of a configuration of a punch out tool for chip on film, and a process of punching out chip on film from resin film tape, according to one embodiment of the present invention;
Figures 3(a)-(d) show one part of a method of manufacture of chip on film according to one embodiment of the present invention;
Figure 4 is a flat view of another configuration of chip on film according to one embodiment of the present invention;
Figure 5 is a flat view of another configuration of chip on film according to one embodiment of the present invention;
Figure 6 is a flat view of another configuration of chip on film according to one embodiment of the present invention;
Figure 7 is a perspective view of a configuration of a punch-out tool for chip on film and a process of punching out chip on film from a resin film tape according to prior art;
Figure 8 shows a process of punching out chip on film from resin film tape; and
Figure 9 is a perspective view of a chip on film according to prior art.

### Detailed Description of Embodiments of the Invention

A chip on film and methods of manufacture thereof according to one embodiment of the present invention, with reference to the drawings, are described in the follwoing. It is noted that the same reference numbers are used in regard to constituent elements that are identical to those according to prior art.

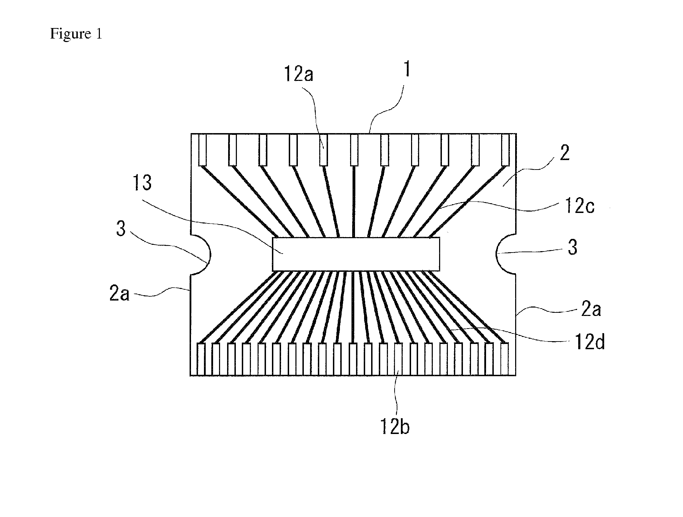

Figure 1 shows the configuration of a chip on film according to the present embodiment. As shown in Figure 1, chip on film 1 has a resin film 2 having an approximately rectangular shape in flat view, and a wiring pattern 12 formed on the mounting surface of resin film 2, and a LSI chip 13 mounted on the mounting surface of resin film 2 and connected to wiring pattern 12. Resin film 2 is approximately rectangular in shape, but differs from prior art in that semicircular cutouts 3 are placed in both short sides 2a thereof. Wiring pattern 12 is comprised of electrodes 12a, 12b, and wiring 12c, 12d etc. connecting the electrodes 12a, 12b and LSI chip 13.

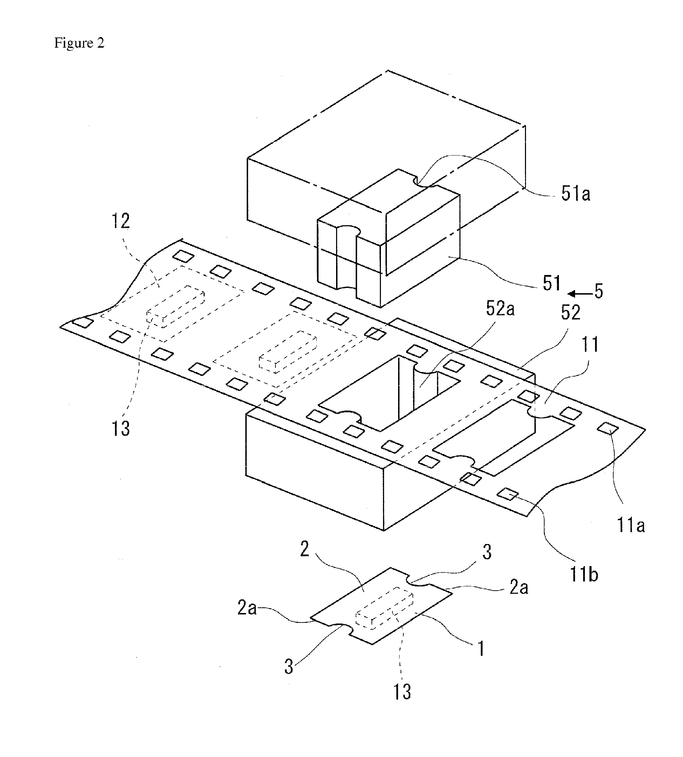

Figure 2 shows the configuration of a punch tool 5 for chip on film 1 and a process for punching chip on film 1 out from a resin film tape 11, according to the present embodiment. Tool 5 is approximately rectangular in shape, and comprises a male tool 51 formed with semicircular cutout(s) 51a in at least one location on the short side(s) thereof, and a female tool 52 formed with semicircular protrusion(s) 52a mating with semicircular cutout part 51a, in at least one location on the short side(s) thereof. By using such a tool 5, it is possible to form cutout part(s) in both short sides of approximately rectangular chip on film 1 as shown in Figure 1.

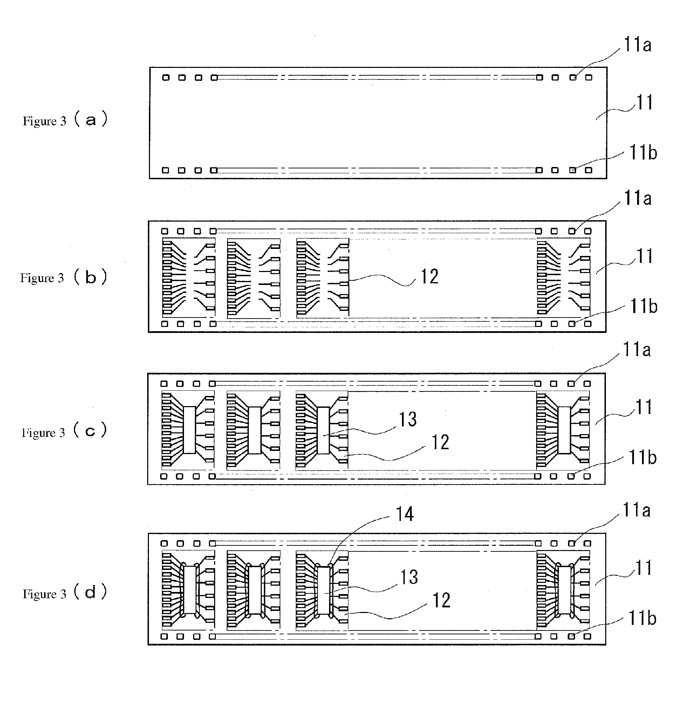

Figure 3 shows a part of a process of manufacture of chip on film according to the present embodiment. In Figure 3, (a) shows formation of perforations 11a, 11b along the longitudinal direction (direction of feed) of a thermosetting resin film tape of polyimide fill etc. The state of continuous formation of designated wiring patterns 12 at regular intervals on resin film tape 11 is shown in (b). Also, (c) shows the state of mounting of LSI chips 13 on the wiring patterns 12. And (d) shows the state of coating the periphery of LSI chips 13 with an adhesive 14 in order to affix them to resin film tape 11. These processes are basically the same as processes of manufacture according to prior art. Subsequently, chip on film 1 is punched out of resin tape 11 using tool 5 as shown in Figure 2.

Thus, by forming cutout parts 3 on each of the short sides of chip on film 1 which is approximately rectangular in flat view, the force causing chip on film 1 to curve in the direction of shrinkage is dissipated or released by the presence of the cutout parts 3. As a result, it is possible to retain excellent flatness in chip on film 1 even after it is punched out by means of tool 5.

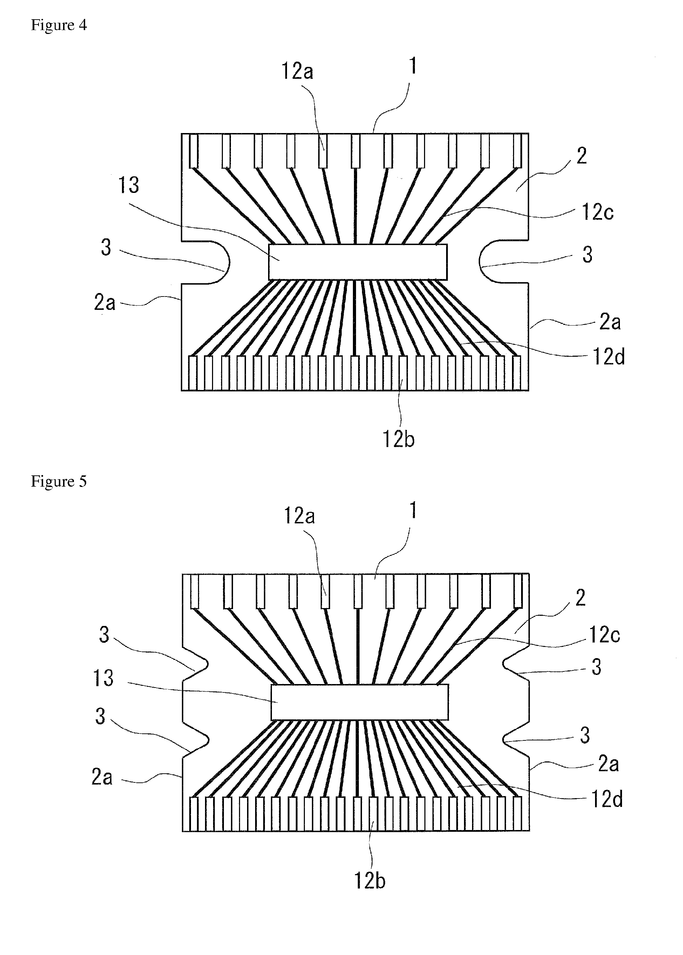

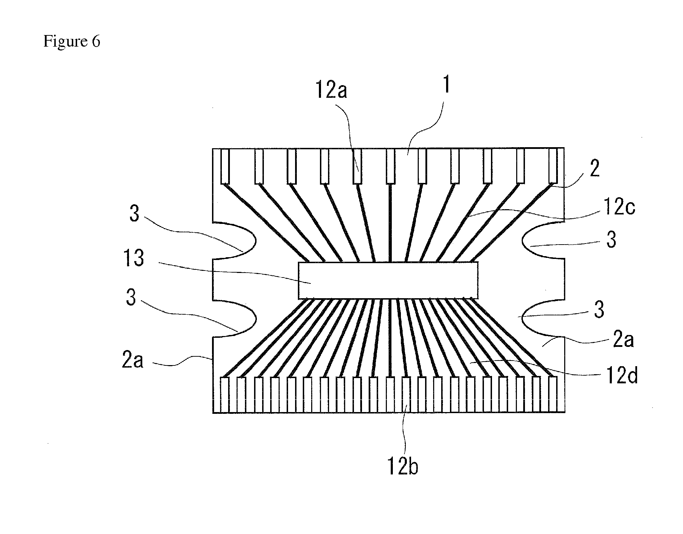

It is noted that the shape of cutout parts 3 is not limited to the aforementioned semicircular shape, but may also be a half oval shape, approximate U shape, or approximate V shape etc. Also, the size thereof is not limited. In addition, as to the number of cutout parts 3, two or more may also be placed in each short side. Figure 4 shows an example wherein cutout parts 3 are approximately U shaped. Also, Figure 5 shows a sample alternate shape in which cutout parts 3 are approximately V-shaped with two placed in each of the short sides of an approximately rectangular shape. Figure 6 shows a sample alternate shape in which cutout parts 3 are approximately half-oval shaped, with two placed in each of the short sides of an approximately rectangular shape. It is noted that in order to prevent breakage of resin film 2 due to concentration of stress, the apex of cutout parts 3 may be formed in a curved shape.

As described above, by means of a chip on film and manufacturing method thereof according to the present invention, cutout parts are formed in at least one place on each of the short sides of an approximately rectangular chip on film punched out of a resin film tape, specifically the edges in the direction of travel of the resin film tape. By means thereof, the force that causes chip on film to curve in the direction of shrinkage is dissipated or released by bye presence of the cutout parts, and it is possible to retain excellent flatness in chip on film even after it is punched out by a tool. As a result, when chip on film is used for purposes such as driving TFTs formed on the surface of a liquid crystal panel, it is possible to perform connection operations in a more trouble-free manner, with less curvature than with prior art, or with virtually no curvature. Also, it is possible to maintain accuracy in positioning when attaching chip on film.

While the invention has been described with respect to a limited number of embodiments, those skilled in the art, having benefit of this disclosure, will appreciate that other embodiments can be devised.

### Explanation of Reference Numbers

1... chip on film
2... resin film
2a... short side of approximately rectangular shape
3... cutout part
5... tool
51... male tool
51a... recessed part
52... female tool
52a... protruding part
11... resin film tape
12... wiring pattern
13... LSI chip
14... adhesive

## Claims

1. A chip on film (1), comprising:
a plastic film (2) approximately rectangular in flat view;
a designated wiring pattern (12) having approximately rectangular electrodes (12a, 12b) arrayed longitudinally formed on a mounting surface of the plastic film (2); and
an LSI chip (13) mounted on the mounting surface of the plastic film (2) and connected to the designated wiring pattern (12),
wherein at least one cutout part (3) is formed on each short side (2a) of the approximate rectangle of the plastic film (2).

2. The chip on film (1) according to claim 1, wherein the at least one cutout part (3) is shaped as one of an approximate semicircle, approximate half-oval, approximate U-shape, or approximate V-shape.

3. A method of manufacture of a chip on film (1), the method comprising:
forming a designated wiring pattern (12) at regular intervals on a plastic film tape (11);
mounting an LSI chip (13) on the designated wiring pattern (12);
coating perimeters of the LSI chip (13) with adhesive (14); and
cutting out from the plastic film wiring pattern areas with the LSI chip (13) mounted in an approximately rectangular shape, wherein the long side is in the lateral direction of the plastic film tape (11), using a tool (5),
wherein the tool (5) comprises:
a male tool (51) approximately rectangular in shape and formed with a cutout part (51a) in at least one place on a short side thereof; and
a female tool (52) approximately rectangular in shape and of approximately the same size as the male tool (51), formed with protrusions (52a) mating with the cutout part (51a) in at least one place on a short side thereof,
wherein a cutout part (3) is formed in at least one place on each of both short sides (2a) of the rectangular form.

4. The method of manufacture of a chip on film (1) according to claim 3, wherein the cutout part (3) is shaped as one of an approximate semicircle, approximate half-oval, approximate U-shape, or approximate V-shape.
